# EUROPEAN PATENT APPLICATION

(11) **EP 3 813 109 A1**
(43) Date of publication of application: **28.04.2021**
(21) Application number: 19882031.8
(22) Date of filing: 27.06.2019
(51) Int. Cl.: H01L 25/075, H01L 33/00

(54) **LED UNIT, LED DISPLAY AND MANUFACTURING METHOD THEREFOR**

(30) Priority: 08.11.2018 CN 201811327548
(71) Applicant: Chengdu Vistar Optoelectronics Co., Ltd., Sichuan 611731 (CN)
(72) Inventor: GUO, Enqing, Chengdu, Sichuan 611731 (CN); MI, Lei, Chengdu, Sichuan 611731 (CN); XING, Rubo, Chengdu, Sichuan 611731 (CN); HUANG, Xiuqi, Chengdu, Sichuan 611731 (CN)
(74) Representative: Neusser, Sebastian
(86) International application number: PCT/CN2019/093334
(87) International publication number: WO 2020/093709

(57) **Abstract**

The present disclosure provides an LED unit. The LED unit could include a light emitting body and a weighing element. The weighing element could be arranged on the light emitting body, such that when the LED unit is in assembly fluid, the LED unit could move in a predefined posture and along a predefined direction driven by the weighing element. The present disclosure also provides a manufacturing method of an LED display. With the above-mentioned implementation, the present disclosure could facilitate the mass transfer of LED units and enhance production efficiency.

## Description

### TECHNICAL FIELD

The present disclosure relates to the field of display technology, and more particular to an LED unit, an LED display and a manufacturing method thereof.

### BACKGROUND

In recent years, the semiconductor lighting technology has become mature, costs thereof have continued to decline, and the industry scale tends to be saturated, which provides better light source devices for the development of the LED display technology.

Micro-LED(Micro-Light Emitting Diode) display technology has advantages of high brightness, high response speed, low power consumption, long service life etc. It has become a research spot for a new generation of display technology. Since Micro-LEDs are currently hard to grow directly on glass substrates and need to be transferred to glass substrates by mass transfer technology, thus the tiny dimension of Micro-LEDs and huge amounts of transfers would bring a lot of challenges to the mass transfer.

Currently, there are too few types of mass transfer methods, which are insufficient with respect of various mass transfer requirements and manufacturing needs of LED displays.

### SUMMARY OF THE DISCLOSURE

A problem mainly solved by the present disclosure is to provide an LED unit, a guide plate, an LED display and manufacturing method thereof, which could facilitate the mass transfer of LED units, thereby improving production efficiency.

To solve the above-mentioned technical problem, a technical solution adopted by the present disclosure is to provide an LED unit. The LED unit could include a light emitting body and a weighing element. The weighing element could be arranged on the light emitting body, such that when the LED unit is in assembly fluid, the LED unit could move in a predefined posture and along a predefined direction driven by the weighing element.

To solve the above-mentioned technical problem, another technical solution adopted by the present disclosure is to provide an LED display. The LED display could include a receiving substrate and multiple LED units. The receiving substrate could be provided with multiple mounting grooves arranged in an array. The LED units could be one-to-one correspondingly mounted in the mounting grooves. The LED units could be the above-mentioned LED units.

To solve the above-mentioned technical problem, a further technical solution adopted by the present disclosure is to provide a manufacturing method of the LED display. The manufacturing method could include: the receiving substrate could be immersed in assembly fluid, the receiving substrate could be provided with multiple mounting grooves arranged in an array; the LED units are placed in the assembly fluid. A weighing element could be arranged on the LED unit, such that the LED unit could move in the predefined posture and along the predefined direction driven by the weighing element, and could fall into the mounting grooves under the gravity action.

To solve the above-mentioned technical problem, another technical solution adopted by the present disclosure is to provide a guide plate. The guide plate could be configured for the manufacturing method of the above-mentioned LED display. Multiple guide holes could be arranged on the guide plate. The guide hole could be configured to switch between an opening state and a closing state.

The guide plate could include a first plate body and a second plate body stacked together. The guide hole could be divided into a first hole segment on the first plate body and a second hole segment on the second plate body. The first plate body and the second plate body could move relative to each other, such that the first hole segment and the second hole segment could be communicating to each other to make the guide hole in an opening state, or the first hole segment and the second hole segment could be misaligned from each other to make the guide hole in a closing state.

The guide plate could include a first plate body, a spacer plate and a second plate body that is stacked with the first plate body and the spacer plate. The guide hole could be divided into a first hole segment on the first plate body and a second hole segment on the second plate body. The spacer plate could move relative to the first plate body and the second plate body, such that the first hole segment and the second hole segment could be communicating to each other to make the guide hole in an opening state, or the first hole segment and the second hole segment could be misaligned from each other to make the guide hole in a closing state.

The first hole segment could be arranged above the second hole segment. The first hole segment could have an inverted cone shape.

In the present disclosure, the LED unit could include a light emitting body and a weighing element, the weighing element could be arranged on the light emitting body, such that when the LED unit is in assembly fluid, the LED unit could move in a predefined posture and along a predefined direction driven by the weighing element. Due to the action of the weighing element, the LED unit could move along a predefined direction, such that when assembled in the assembly fluid, the LED units could smoothly enter into the mounting grooves, thereby facilitating the mass transfer of the LED units, preventing the receiving substrate from being refilled with too many LED units, thereby improving production efficiency.

### BRIEF DESCRIPTION OF THE DRAWINGS

In order to more clearly illustrate technical solutions in the present disclosure, the drawings required in the description of the embodiments will be briefly introduced below. Obviously, the drawings in the following description are only some embodiments of the present disclosure. For those of ordinary skills in the art, other drawings could be obtained based on these drawings without creative efforts. Among the drawings:
Fig. 1 is a schematic structural diagram of an LED unit according a first embodiment of the present disclosure.
Fig. 2 is a schematic structural diagram of a receiving substrate according to some embodiments of the present disclosure.
Fig. 3 is a schematic structural diagram of an LED unit according a second embodiment of the present disclosure.
Fig. 4 is a schematic structural diagram of an LED unit according a third embodiment of the present disclosure.
Fig. 5 is a top view of a second contact electrode according to some embodiments of the present disclosure.
Fig. 6 is a top view of another second contact electrode according to some embodiments of the present disclosure.
Fig. 7 is a flow chart of a manufacturing method of an LED display according to a first embodiment of the present disclosure.
Fig. 8 is a flow chart of a manufacturing method of an LED display according to a second embodiment of the present disclosure.
Fig. 9 is a schematic diagram of a manufacturing procedure of the manufacturing method of the LED display according to the second embodiment of the present disclosure.
Fig. 10 is a schematic structural diagram of another guide plate according to some embodiment of the present disclosure.
Fig. 11 is a schematic structural diagram of an LED display according to some embodiments of the present disclosure.

### DETAILED DESCRIPTION

Technical solutions in embodiments of the present disclosure will be described clearly and thoroughly in connection with accompanying drawing of the embodiments of the present disclosure. Obviously, the described embodiments are only a part of the embodiments, but not all of them. All other embodiments obtained by a person of ordinary skills in the art based on embodiments of the present disclosure without creative efforts shall all be within the protection scope of the present disclosure.

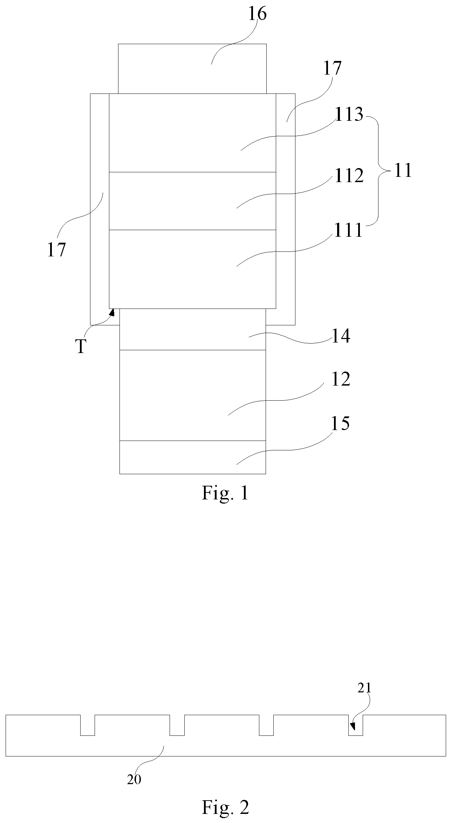

Please referring to Fig. 1, Fig. 1 is a schematic structural diagram of an LED unit according to the first embodiment of the present disclosure.

In the present embodiment, the LED unit could include a light emitting body 11 and a weighing element 12. The weighing element 12 could be arranged on the light emitting body 11, such that when the LED unit is in assembly fluid, the LED unit could move in a predefined posture and along a predefined direction driven by the weighing element 12.

Due to the action of the weighing element 12, the LED unit could move along the predefined direction, such that when being assembled in the assembly fluid, the LED unit could smoothly enter into a mounting groove, preventing a receiving substrate from being refilled with too many LED units, thereby improving production efficiency.

In some embodiments, the light emitting body 11 could include multiple stacked function layers. In the predefined posture, a stacking direction of the multiple function layers could be parallel with a vertical direction.

The stacking direction may refer to the direction perpendicular to contact surfaces between every function layer.

The predefined direction may refer to a vertically downward direction. In other embodiments, as long as the LED unit is kept being in the predefined posture, the predefined direction could be any other directions. For example, the LED unit could move in the assembly fluid along an obliquely downward direction under the influence of the assembly fluid.

In some embodiments, the light emitting body 11 could include multiple stacked function layers. In the predefined posture, an angle between the stacking direction of the multiple function layers and the vertical direction could be defined as the predefined angle.

In some embodiments, the predefined angle could be greater than 0 degrees and less than 30 degrees. In other embodiments, the predefined angle could be other angles, which is not limited in embodiments of the present disclosure.

In some embodiments, in an implementation, when the LED unit is placed in the assembly fluid, the weighing element 12 could be in a position lower than that of the light emitting body 11 due to the action of the weighing element 12, thus the weighing element 12 is more adjacent to the receiving substrate than the light emitting body 11. For example, this could be implemented by setting a density of the weighing element 12 to be greater than that of the light emitting body 11.

In some embodiments, in an implementation, when the LED unit is placed in the assembly fluid, the light emitting body 11 could be in a position lower than that of the weighing element 12 due to the action of the weighing element 12, thus the light emitting body 11 is more adjacent to the receiving substrate than the weighing element 12. For example, this could be implemented by setting a density of the weighing element 12 to be less than that of the light emitting body 11.

Through the above-mentioned implementations, the weighing element 12 is set to make sure that the LED unit could fall to the receiving substrate in the predefined posture in the assembly fluid, and an opening direction of the mounting grooves on the receiving substrate could be corresponding to the predefined posture, thus the LED unit could enter into the mounting grooves smoothly.

In some embodiments, the multiple function layers could include a first semiconductor layer 111, the light emitting layer 112 and a second semiconductor 113 that is stacked with the first semiconductor layer 111 and the light emitting layer 112.

It should be appreciated that, a structure of the multiple function layers is not limited to the above-mentioned structure. On the contrary, the light emitting body 11 may also have other LED structures, or stacking structures of other electroluminescence components.

In some embodiments, the first semiconductor layer 111 could be a P-type semiconductor layer. The second semiconductor layer 113 could be an N-type semiconductor layer.

In other embodiments, the first semiconductor layer 111 could be an N-type semiconductor layer. Accordingly, the second semiconductor layer 113 could be a P-type semiconductor layer. Embodiments of the present disclosure do not impose any limitation on this.

In some embodiments, the weighing element 12 could be arranged on one side of the first semiconductor layer 111 or the second semiconductor 113 away from the light emitting layer 112.

Please referring to Fig. 2, Fig. 2 is a schematic structural diagram of the receiving substrate according to some embodiments of the present disclosure. The receiving substrate 20 may be arranged on a horizontal deposition plane. The receiving substrate 20 could be provided with multiple mounting grooves 21 arranged in an array. The opening direction of mounting grooves 21 of the receiving substrate 20 could be perpendicular to the surface of the receiving substrate 20.

In these cases, when the LED unit is moving in the assembly fluid, the weighing element 12 could ensure the stacking direction of the first semiconductor layer 111, the light emitting layer 112 and the second semiconductor layer 113 to be configured along the vertical direction to smoothly enter the LED unit into the mounting grooves 21.

It will be understood that, when the deposition location of the receiving substrate 20 varies or the opening direction of the mounting grooves 21 changes, and the opening direction of the mounting groove 21 is no longer along the vertical direction, through adjustments of the deposition location, density, shape etc of the weighing element 12, the LED unit could move in the predefined posture and along the predefined direction driven by the weighing element when the LED unit is placed in the assembly fluid, the predefined posture matches with the opening direction of the mounting grooves, thus the LED unit could smoothly enter into the mounting grooves. The predefined posture is not limited to a posture in which the stacking direction of the multiple function layers are parallel to the vertical direction.

In some embodiments, the LED unit could further include a first contact electrode 14. The first contact electrode 14 could be set on one side of the first semiconductor layer 111 away from the light emitting layer 112. The weighing element 12 could be set on one side of the first contact electrode 14 away from the first semiconductor layer 111.

In some embodiments, the density of the weighing element 12 is greater than that of the light emitting body 11, such that when the LED unit is moving in the assembly fluid, the first contact electrode 14 is on the downward side of the light emitting body 11, thus the first contact electrode 14 is more adjacent to the receiving substrate 20 than the light emitting body 11.

In some embodiments, the LED unit could further include a welding electrode 15. The welding electrode 15 could be arranged on one side of the weighing element 12 away from the first contact electrode 14. The welding electrode 15 could be electrically connected to the first contact electrode 14 through the weighing element 12.

The welding electrode 15 could be configured for welding with the receiving substrate 20 after the LED unit has fallen into the mounting groove 21. In other embodiments, the welding electrode 15 could be omitted, and the weighing element 12 could be configured to directly weld with the receiving substrate 20.

In some embodiments, the LED unit could further include a second contact electrode 16. The second contact electrode 16 could be arranged on one side of the second semiconductor layer 113 away from the light emitting layer 112. The density of the weighing element 12 could be further greater than that of the second contact electrode 16.

In the present embodiment, the first contact electrode 14 could be a P-type electrode. The second contact electrode 16 could be an N-type electrode.

In other embodiments, the density of the weighing element 12 could be less than that of the light emitting body 11, such that the second contact electrode 16 could be on the downward side of the LED unit when the LED unit is placed in the assembly fluid. The second contact electrode 16 could be configured to weld with the receiving substrate, which is not limited in the present disclosure. Accordingly, the first contact electrode 14 could be an N-type electrode, and the second contact electrode 16 could be a P-type electrode.

In some embodiments, the LED unit could further include an insulation protection layer 17. The insulation protection layer 17 could be disposed on peripheral surfaces of the light emitting body 11.

The insulation protection layer 17 could be configured to protect the light emitting body 11 and insulate the light emitting body 11 from the atmosphere, thus preventing a side wall current leakage passage from occurring in the LED unit.

In some embodiments, a cross-sectional area of the light emitting body 11 is greater than a cross-sectional area of the first contact electrode 14, such that a step T is formed between the light emitting body 11 and the first contact electrode 14. The insulation protection layer 17 could be further arranged on the step T.

In some embodiments, a cross-sectional area of the light emitting body 11 could be greater than a cross-sectional area of the weighing element 12. The cross-sectional area of the light emitting body 11 could be greater than a cross-sectional area of the welding electrode 15. The cross-sectional area of the light emitting body 11 could be greater than a cross-sectional area of the second contact electrode 16.

In some embodiments, any one of the cross-sectional area of the welding electrode 15, the cross-sectional area of the weighing element 12, the cross-sectional area of the first contact electrode 14, and the cross-sectional area of the second contact electrode 16 is equal to another one thereof, and outer peripheral surfaces of the welding electrode 15, the weighing element 12, the first contact electrode 14, and the second contact electrode 16 could be arranged to be flush with another one thereof.

In some embodiments, a cross section of the light emitting body 11, a cross section of the welding electrode 15, a cross section of the weighing element 12, a cross section of the first contact electrode 14, a cross section of the second contact electrode 16 could all be circular. Accordingly, a cross section of a mounting groove 21 could be circular.

Since the LED unit has a circular cross section anywhere along the stacking direction of each film layer, thus however the LED unit rotates around its axis, its cross section would always match with the circular cross section of the mounting groove 21. In other words, the circular shapes are not anisotropic, thus avoiding a problem that the LED unit could not enter into the mounting groove 21 after rotating a certain angle. For example, an LED unit having a square shaped cross section could hardly enter into a square shaped mounting groove after rotating a certain angle around its center.

It should be appreciated that, when the influence of the cross sectional shape to a transferring success chance rate of the LED unit's transferring to the mounting groove is not considered, the cross section of the LED unit could be set as other shapes, such as a square, as long as the weight element is provided, and the success chance rate could be improved, which is not limited in the present disclosure.

In the present embodiment, cross sections at anywhere along the stacking direction of the first semiconductor layer 111, the light emitting layer 112 and the second semiconductor layer 113 of the light emitting body 11 are identical, and are all circular. That is, the light emitting body 11 could have a cylindrical shape as a whole.

In other embodiments, the light emitting body 11 could be a circular truncated cone. Referring to the following description of the embodiments for details.

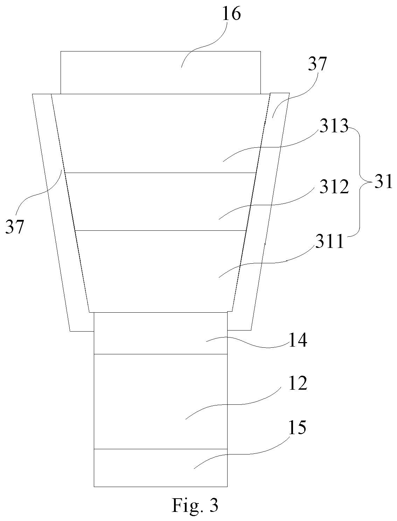

Please referring to Fig. 3, Fig. 3 is a schematic structural diagram of an LED unit according to a second embodiment of the present disclosure.

In the present embodiment, the light emitting body 31 could be a circular truncated cone on the whole. The first semiconductor layer 311, the light emitting layer 312 and the second semiconductor layer 313 of the light emitting body 31 could each have a circular cross section.

The cross-sectional area of the first semiconductor layer 311 could be less than the cross-sectional area of the light emitting layer 312. The cross-sectional area of the light emitting layer 312 could be less than the cross-sectional area of the second semiconductor layer 313.

In this way, driven by the weighing element 12, when the first contact electrode 14 is on the downward side, an end of the circular-truncated-cone shaped light emitting body 31 whose cross-sectional area is smaller could be on the downward side, thereby facilitating the LED unit's falling into the mounting groove 21. In this situation, the first semiconductor layer 311 could be a P-type semiconductor layer, the second semiconductor layer 311 could be an N-type semiconductor layer. Accordingly, the first contact electrode 14 could be a P-type electrode, the second contact electrode could be an N-type electrode.

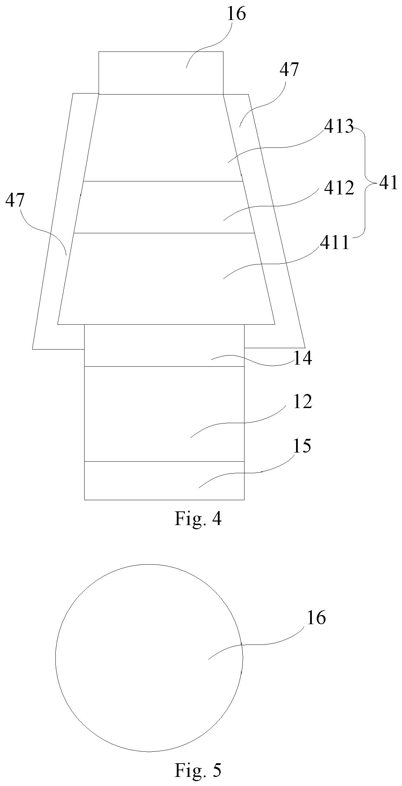

Please referring to Fig. 4, Fig. 4 is a schematic structural diagram of an LED unit according to a third embodiment of the present disclosure.

In the present embodiment, the light emitting body 41 could be a circular truncated cone on the whole. The first semiconductor layer 411, the light emitting layer 412 and the second semiconductor layer 413 of the light emitting body 41 could each have a circular cross section.

The cross-sectional area of the first semiconductor layer 411 could be greater than the cross-sectional area of the light emitting layer 412. The cross-sectional area of the light emitting layer 412 could be greater than the cross-sectional area of the second semiconductor layer 413. In this situation, the first semiconductor layer 411 could be an N-type semiconductor layer, the second semiconductor layer 311 could be a P-type semiconductor layer. Accordingly, the first contact electrode 14 could be an N-type electrode, and the second contact electrode 14 could be a P-type electrode.

Please referring to Fig. 5, Fig. 5 is a top view schematic structural diagram of a second contact electrode according to some embodiments of the present disclosure.

In some embodiments, the light emitting layers 112, 212 or 312 could emit light through the second contact electrode 16. In the present embodiment, the second contact electrode 16 could be cylindrical, and a material of the second contact electrode 16 comprises transparent conductive material. Thus the light emitting layers 112, 212 or 312 could successively emit light, and the second contact electrode 16 would not obscure the light.

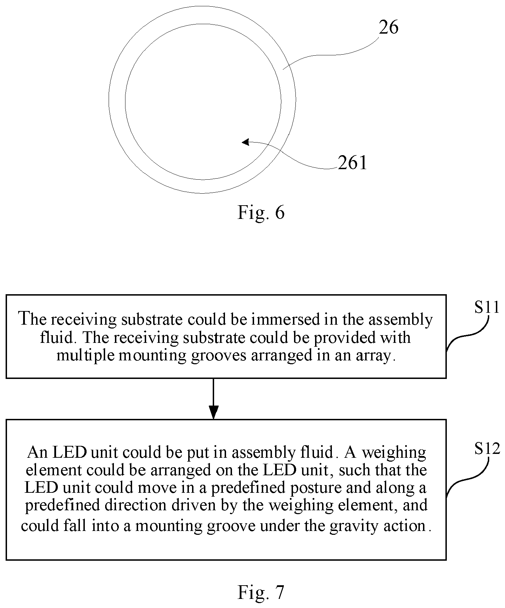

Please referring to Fig. 6, Fig. 6 is a top view schematic structural diagram of another kind of the second contact electrode according to some embodiments of the present disclosure.

In the present disclosure, the second contact electrode 26 could be ring-shaped. Thus the light emitting layer 112, 212 or 312 could successively emit light through a hollow position 261 of the ring-shaped second contact electrode 26, and the second contact electrode 26 would not obscure the light.

In any one of the above-mentioned embodiments, the diametrical dimension of the LED unit could be ranged from 1 micrometer to 100 micrometer, and the axial dimension of the LED unit could be ranged from 0.5 micrometer to 10 micrometer.

Please referring to Fig. 7, Fig. 7 is a flow chart of a manufacturing method of an LED display according to a first embodiment of the present disclosure.

In the present embodiment, the manufacturing method of the LED display could include the following operations.

At block S11: immersing the receiving substrate in the assembly fluid. The receiving substrate could be provided with multiple mounting grooves arranged in an array.

The receiving substrate 20 could be put in an assembly fluid container. Assembly fluid could be poured into the assembly fluid container, such that the receiving substrate 20 could be immersed in the assembly fluid. As is shown in Fig. 2, the receiving substrate 20 could be provided with multiple mounting grooves 21 arranged in an array. The receiving substrate 20 may specifically be a glass substrate. Each mounting groove 21 could correspond to a sub-pixel (for example, RGB red, green and blue three-color sub-pixel, or RGBW four-color sub-pixel).

In an implementation, the LED units of different colors could have different dimensions. The mounting groove at a location corresponding to a sub-pixel of a specific color could have a dimension matching with the sub-pixel, thereby ensuring that the LED unit of a certain color could smoothly fall into a mounting groove configured for that color.

In another implementation, the LED units of different colors could have different dimensions. An opening of a guide hole at a location corresponding to a sub-pixel of a specific color could have a dimension matching with the sub-pixel, thereby ensuring that the LED unit of a certain color could smoothly fall into a mounting groove configured for that color.

In another implementation, LED units of identical colors could be disposed in mounting grooves at locations of sub-pixels of different colors. In the subsequent manufacturing procedures, on an LED unit of a sub-pixel corresponding to a specific color, a light conversion layer corresponding to the specific color could be fabricated. For example, all LED units could be blue LEDs that emits blue excitation light. The blue excitation light could then be converted into red, green, blue or white light through a light conversion layer.

At block S12: putting an LED unit in assembly fluid. A weighing element could be arranged on the LED unit, such that the LED unit could move in a predefined posture and along a predefined direction driven by the weighing element, and could fall into a mounting groove under the gravity action.

The LED unit that is placed in the assembly fluid is an LED unit from any one of the above-mentioned embodiments.

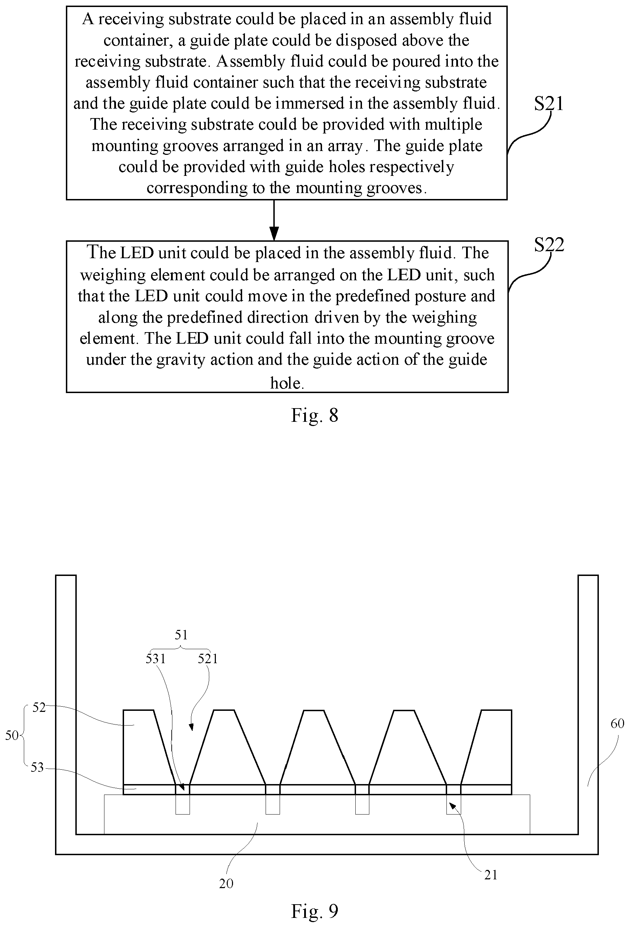

Please referring to Fig. 8, Fig. 8 is a flow chart of the manufacturing method of an LED display according to a second embodiment of the present disclosure.

In the present embodiment, the manufacturing method of the LED display could include the following operations.

At block S21: a receiving substrate could be put in an assembly fluid container, a guide plate could be disposed above the receiving substrate. Assembly fluid could be poured into the assembly fluid container such that the receiving substrate and the guide plate could be immersed in the assembly fluid. The receiving substrate could be provided with multiple mounting grooves arranged in an array. The guide plate could be provided with guide holes respectively corresponding to the mounting grooves.

As is shown in Fig. 9, Fig. 9 is a schematic diagram of a manufacturing procedure of the manufacturing method of an LED display according to the second embodiment of the present disclosure. The receiving substrate 20 could be provided with multiple mounting grooves 21 arranged in an array. The guide plate 50 could be provided with guide holes 51 respectively corresponding to the mounting grooves 21. The receiving substrate 20 could be placed in the assembly fluid container 60. The guide plate 50 could be disposed above the receiving substrate 20, such that a location of the guide hole 51 could correspond to a location of the mounting groove 21.

At block S22: the LED unit could be placed in the assembly fluid. The weighing element could be arranged on the LED unit, such that the LED unit could move in the predefined posture and along the predefined direction driven by the weighing element. The LED unit could fall into the mounting groove under the gravity action and the guide action of the guide hole.

The LED unit that is placed in the assembly fluid could be an LED unit from any one of the above-mentioned embodiment. The particular way of putting is: suspension liquid of LED units could be pre-prepared, and the suspension liquid of the LED units could then be added into the assembly fluid.

The guide hole 51 could be configured to switch between an opening state and a closing state. In the opening state, the guide hole 51 could allow the LED units to pass through. In the closing state, the guide hole 51 may not allow the LED units to pass through.

The step of LED units being placed in the assembly fluid may specifically include: the guide holes 51 could be set in the opening state; the LED units could be placed in the assembly fluid.

After the LED units have been placed in the assembly fluid, the method could further include: the guide hole 51 could be switched from the opening state to the closing state, the receiving substrate 20 and the guide plate 50 could be removed from the assembly fluid.

In some embodiments, the guide plate 50 could include a first plate body 52 and a second plate body 53 that is stacked with the first plate body 52. The guide hole 51 could be divided into a first hole segment 521 on the first plate body 52 and a second hole segment 531 on the second plate body 53. The first plate body 52 and the second plate body 53 could move with respect to each other, such that the first hole segment 521 and the second hole segment 531 could communicate with each other, thereby the guide hole 51 is in an opening state, or the first hole segment 521 and the second hole segment 531 could be misaligned from each other, thereby the guide hole 51 is in a closing state.

In some embodiments, the first hole segment 521 could be arranged above the second hole segment 531, and the first hole segment 521 could be arranged in an inverted cone form. By providing an inverted cone-shaped first hole segment 521, the upper opening of the guide hole 51 is larger, thus it is more easy to receive the LED units.

After step S22, the method could further include: the welding electrode 15 of the LED unit could be welded with the receiving substrate 20.

In some embodiments, a concrete way of welding could be: the receiving substrate 20 could be placed in a reflow oven to perform reflow soldering, thereby fixing the LED units in the mounting grooves 21, thus completing the mass transfer process.

It should be appreciated that, the manner in which the guide plate could be opened and closed is not limited to the above-mentioned structure, other structures may be used, which is not limited in embodiments of the present disclosure.

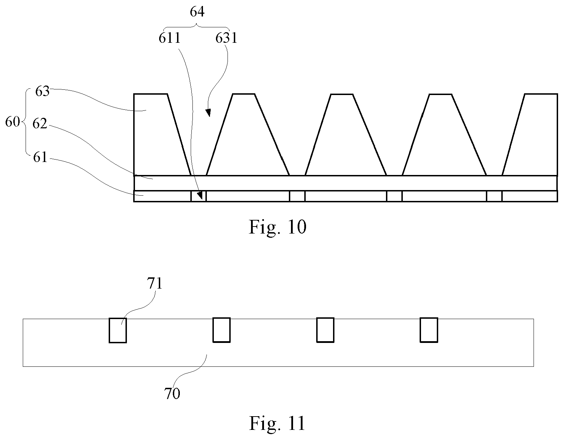

Please referring to Fig. 10, Fig. 10 is a schematic structural diagram of another guide plate according to an embodiment of the present disclosure. For example, the guide plate 60 could include a first plate body 61, a spacer plate 62, a second plate body 63 that are stacked successively. A guide hole 64 could be divided into a first hole segment 611 on the first plate body 61 and a second hole segment 631 on the second plate body 63. The spacer plate 62 could move relative to the first plate body 61 and the second plate body 63, such that the guide hole 64 could be in an opening state in which the first hole segment 611 and the second hole segment 631 are communicating to each other or in a closing state in which the first hole segment 611 and the second hole segment 631 are misaligned from each other.

Please referring to Fig. 11, Fig. 11 is a schematic structural diagram of an LED display according to some embodiments of the present disclosure.

In the present embodiment, the LED display could include a receiving substrate 71 and multiple LED units 72. The receiving substrate 71 could be provided with multiple mounting grooves arranged in an array. The LED units 72 could be one-to-one correspondingly mounted in the mounting grooves. The LED unit 72 could be an LED unit from any one of the above-mentioned embodiments.

In the present disclosure, the LED unit could include a light emitting body and a weighing element, the weighing element is arranged on the light emitting body, such that when the LED unit is placed in assembly fluid, the LED unit could move in a predefined posture and along a predefined direction driven by the weighing element. Due to the action of the weighing element, the LED unit could move along the predefined direction, such that when being assembled in the fluid, the LED unit could smoothly enter into a mounting groove, preventing the receiving substrate from being refilled with too many LED units, thereby improving production efficiency.

The above are only implementations of the present disclosure, and do not limit the patent scope of the present disclosure. Any equivalent changes to the structure or processes made by the description and drawings of this application or directly or indirectly used in other related technical field are included in the protection scope of this application.

## Claims

1. An LED unit, comprising:
a light emitting body;
a weighing element, arranged on the light emitting body, wherein when the LED unit is in assembly fluid, the LED unit can move in a predefined posture and along a predefined direction driven by the weighing element.

2. The LED unit according to claim 1, wherein the light emitting body comprises a plurality of stacked function layers, and when the LED unit is in the predefined posture, a stacking direction of the plurality of function layers is parallel with a vertical direction.

3. The LED unit according to claim 1, wherein the light emitting body comprises a plurality of stacked function layers, and when the LED unit is in the predefined posture, an angle between a stacking direction of the plurality of function layers and a vertical direction is defined as a predefined angle.

4. The LED unit according to claim 3, wherein the predefined angle is greater than 0 degrees and less than 30 degrees.

5. The LED unit according to claim 3, wherein the plurality of function layers comprise a first semiconductor layer, a light emitting layer and a second semiconductor layer that is stacked with the first semiconductor layer and the light emitting layer , and the weighing element is arranged on one side of the first semiconductor layer or the second semiconductor layer away from the light emitting layer .

6. The LED unit according to claim 5, wherein the LED unit further comprises a first contact electrode, the first contact electrode is arranged on one side of the first semiconductor layer far-away from the light emitting layer , the weighing element is arranged on one side of the first contact electrode away from the first semiconductor layer, and a density of the weighing element is greater than a density of the light emitting body, such that when the LED unit is placed in the assembly fluid, the first contact electrode is on the downward side of the LED unit.

7. The LED unit according to claim 6, wherein the LED unit further comprises a welding electrode, the welding electrode is arranged on one side of the weighing element away from the first contact electrode, and the welding electrode is electrically connected to the first contact electrode through the weighing element.

8. The LED unit according to claim 6, wherein the LED unit further comprises a second contact electrode, the second contact electrode is arranged on one side of the second semiconductor layer away from the light emitting layer , and the density of the weighing element is further greater than a density of the second contact electrode.

9. The LED unit according to claim 1, wherein a density of the weighing element is less than a density of the light emitting body.

10. The LED unit according to claim 6, wherein a cross-sectional area of the light emitting body is greater than a cross-sectional area of the first contact electrode.

11. The LED unit according to claim 5, wherein the light emitting body has a shape of a circular truncated cone, cross sections of the first semiconductor layer, the light emitting layer and the second semiconductor layer are all circular, a cross-sectional area of the first semiconductor layer is less than a cross-sectional area of the light emitting layer , and a cross-sectional area of the light emitting layer is less than a cross-sectional area of the second semiconductor layer .

12. The LED unit according to claim 8, wherein the second contact electrode is cylindrical, and the material of the second contact electrode comprises transparent conductive material; or
the second contact electrode is ring-shaped.

13. An LED display, comprising:
a receiving substrate and a plurality of LED units,
the receiving substrate provided with a plurality of mounting grooves arranged in an array, the plurality of LED units one-to-one correspondingly mounted in the plurality of mounting grooves, the LED units comprising:
a light emitting body;
a weighing element, arranged on the light emitting body, wherein when the LED unit is placed in assembly fluid, the LED unit can move in a predefined posture and along a predefined direction driven by the weighing element.

14. A manufacturing method of an LED display, comprising:
immersing a receiving substrate in assembly fluid, the receiving substrate being provided with a plurality of mounting grooves arranged in an array;
putting an LED unit in the assembly fluid, the LED unit being provided with a weighing element to move the LED unit in a predefined posture and along a predefined direction driven by the weighing element, and falling the LED unit into the mounting groove under the gravity action.

15. The method according to claim 14, wherein the immersing a receiving substrate in assembly fluid further comprises:
arranging a guide plate on the receiving substrate , the guide plate being provided with guide holes respectively corresponding to the mounting grooves to fall the LED unit into a mounting groove guiding by a guide hole.

16. The method according to claim 15, wherein the guide hole is configured to switch between an opening state and a closing state;
the putting an LED unit in the assembly fluid further comprise: setting the guide hole in an opening state; and
after the putting an LED unit in the assembly fluid, the method further comprises: switching the guide hole from an opening state to a closing state, and removing the receiving substrate and the guide plate from the assembly fluid.

17. The method according to claim 16, wherein the guide plate comprises a first plate body and a second plate body that is stacked with the first plate body , the guide hole is divided into a first hole segment in the first plate body and a second hole segment in the second plate body , the first plate body and the second plate body are configured to move relative to each other to communicate the first hole segment with the second hole segment to make the guide hole in the opening state, or misalign the first hole segment with the second hole segment to make the guide hole in the closing state.

18. The method according to claim 16, wherein the guide plate comprises a first plate body , a spacer plate and a second plate body that is stacked with the first plate body and the spacer plate, the guide hole is divided into a first hole segment in the first plate body and a second hole segment in the second plate body , the spacer plate is configured to move relative to the first plate body and the second plate body to communicate the first hole segment with the second hole segment to make the guide hole in an opening state, or misalign the first hole segment with the second hole segment to make the guide hole in a closing state.

19. The method according to claim 17, wherein the first hole segment is arranged above the second hole segment, and the first hole segment is arranged in an inverted cone shape.

20. The method according to claim 18, wherein the first hole segment is arranged above the second hole segment, and the first hole segment is arranged in an inverted cone shape.
